# EUROPEAN PATENT SPECIFICATION

(11) **EP 2 945 997 B1**
(45) Date of publication and mention of the grant of the patent: **05.10.2016**
(21) Application number: 13811794.0
(22) Date of filing: 18.12.2013
(51) Int. Cl.: C09K 11/77

(54) **ALUMOSILICATE-BASED PHOSPHORS**
LEUCHTSTOFFE AUF DER BASIS VON ALUMOSILIKATEN
PHOSPHORES À BASE D'ALUMINOSILICATE

(30) Priority: 15.01.2013 EP 13000181
(43) Date of publication of application: 25.11.2015
(73) Proprietor: Merck Patent GmbH, 64293 Darmstadt (DE)
(72) Inventor: OKURA, Hiroshi, Hiratsuka-shi Kanagawa 254-0821 (JP); WAKIMOTO, Takeo, Tokyo 108-0014 (JP); MATSUI, Katsuyuki, Tokyo 183-0035 (JP); MATSUDA, Noriyuki, Chiba-Shi Chiba 261-0011 (JP)
(86) International application number: PCT/EP2013/003828
(87) International publication number: WO 2014/111115

(56) References cited:
- EP-A1- 1 710 289
- EP-A1- 1 900 790
- ES-T3- 2 368 852
- WOAN-JEN YANG ET AL: "Luminescence and Energy Transfer of Eu- and Mn-Coactivated CaAl 2 Si 2 O 8 as a Potential Phosphor for White-Light UVLED", CHEMISTRY OF MATERIALS, vol. 17, no. 15, 1 July 2005 (2005-07-01), pages 3883-3888, XP055110007, ISSN: 0897-4756, DOI: 10.1021/cm050638f
- GURIN N T ET AL: "White, green, and yellow photoluminescence in the (CaO Â AlOÂ SiO): Eu system", TECHNICAL PHYSICS, NAUKA/INTERPERIODICA, MO, vol. 57, no. 1, 6 January 2012 (2012-01-06), pages 74-77, XP019998100, ISSN: 1090-6525, DOI: 10.1134/S1063784212010124
- XU ET AL: "Highly efficient red, green and blue upconversion luminescence of Eu<3+>/Tb<3+>-codoped silicate by femtosecond laser irradiation", CHEMICAL PHYSICS LETTERS, ELSEVIER BV, NL, vol. 442, no. 4-6, 4 July 2007 (2007-07-04), pages 492-495, XP022142291, ISSN: 0009-2614, DOI: 10.1016/J.CPLETT.2007.06.014
- JINSU ZHANG ET AL: "Paper;White long-lasting phosphorescence generation in a CaAl2Si2O8 : Eu2+, Mn2+, Dy3+ system through persistent energy transfer;White long-lasting phosphorescence generation in a CaAl2Si2O8 : Eu2+, Mn2+, Dy3+ system through persistent energy transfer", JOURNAL OF PHYSICS D: APPLIED PHYSICS, INSTITUTE OF PHYSICS PUBLISHING LTD, GB, vol. 45, no. 32, 30 July 2012 (2012-07-30) , page 325105, XP020226746, ISSN: 0022-3727, DOI: 10.1088/0022-3727/45/32/325105

## Description

### Field of the Invention

The invention relates to co-activated alumosilicate based phosphors and to the preparation thereof. The invention further relates to the use of these phosphors in electronic and electrooptical devices, such as light emitting diodes (LEDs) and solar cells. The invention further relates to illumination units that comprise said silicate-based phosphors and LCD backlighting systems.

### Background and Prior Art

White light-emitting diodes (LEDs) are regarded as the next-generation light source because of their high efficiency, long lifetime, less environmental impact, absence of mercury, short response times, applicability in final products of various sizes, and many more favorable properties. White LEDs are gaining attention as backlight sources for liquid crystal displays, in lighting, computer notebook monitors, and cell phone screens. They are prepared by adding phosphors emitting yellow light, such as YAG:Ce that emits yellow light (560 nm) to a blue LED. Phosphors used in white LEDs are excited by light emission from blue LEDs. The peak wavelength of the blue LEDs is in the range from 450 to 470 nm, therefore, only a limited number of phosphors can be used for white LEDs. Therefore, the development of phosphors other than YAG:Ce is highly desirable.

By using red, green, and blue phosphors with a chip emitting light with a wavelength ranging from 380 to 410 nm as an energy source, it is possible to obtain a three-color white LED with better luminescence strength and superior white color. Consequently, LED producers are now demanding phosphors that can be excited in the wavelength range of 380 to 410 nm.

To make white LEDs by using UV-LEDs or near UV-LEDs, red, green, and blue phosphors are first mixed in a resin. Next, a resultant gel is put on a UV-LED chip or a near UV-LED chip and hardened with UV irradiation, annealing, or similar processes. One can observe an even, white color while looking at the chip from all angles, if the phosphors in the resin are homogeneously dispersed. However, it is difficult to mix uniformly phosphors of different sizes and density in the resin. Therefore, it would have advantages to use less than three phosphors. For example, it is desirable to use a phosphor that presents two or more strong emission peaks at different wavelengths, which might result in the use of less different kinds of phosphors.

Furthermore, when a mixture of two or more phosphors is used to produce white LEDs using UV or near UV-LEDs, the excitation wavelength of each phosphor should not exist in a visible range. For instance, if the emission spectrum of the green phosphor overlaps with the excitation spectrum of the red phosphor, then color tuning would become difficult. If a mixture of two or more phosphors is used to produce white LEDs using a blue emitting LED as the primary light source, the excitation wavelength of the phosphors should overlap with the blue emission wavelength of the LED.

Therefore, two or more phosphors, particularly those emitting red, become indispensible for creating high color rendering white LEDs using UV-LEDs or near UV-LEDs.

For the purpose of the present invention, near UV-LEDs are taken to mean LEDs that emit light with a main emission peak wavelength between 300 nm and 410 nm.

Additionally, UV-LEDs are taken to mean LEDs that emit light with a main emission peak wavelength between 250 nm and 410 nm.

Woan-Jen Yang, Liyang Luo, Teng-Ming Chen, and Niann-Shia Wang, Chem. Mater., 2005, 17 (15), 3883-3888 describe an alumosilicate-based phosphor of the general formula CaAl₂Si₂O₈ : Eu²⁺, Mn²⁺. The main emission peak is 425 nm and the range of the sub emission peak is from 550 to 570 nm.

Shiqing Xu, Wei Wang, Shifeng Zhu, Bin Zhu and Jianrong Qiu, Chem. 3+ 3+ Phys. Lett., 2007, 442, 492-495 describe Eu /Tb - codoped CaO-Al₂O₃-SiO₂ glasses.
N. T. Gurin, K. V. Paksyutov, M. A. Terent'ev and A. V. Shirokov, Technical Physics, 2012, 57(1), 74-77 describe Eu - doped CaO-Al₂O₃-SiO₂phosphors.

WO 2008/047965 (Lucimea Co., Ltd) describes a luminescent material of the formula (Ca,Sr,Ba)_{α}Si_{β}O_{γ} :Eu, Mn, M, N, wherein M is at least one cation selected from the group consisting of Ce, Pr, Sm, Gd, Tb, Dy, Ho, Er, Tm and Yb, and N is at least one cation selected from the group consisting of Li, Na, K, Al, Ga, In and Y.

WO 2012/025185 (Merck) describes silicate based phosphors according to the formula (Aₓ, B_{y},M_{1-x-y}) SiO₃ · (Si02)n wherein M is at least one cation selected from the group consisting of Ca, Sr, Ba and wherein A and B are independent from each other at least one element selected from the group consisting of Sc³⁺, Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺, Bi³⁺, Pb²⁺, Mn²⁺, Yb²⁺, Sm²⁺, Eu²⁺, Dy²⁺, and Ho²⁺.

WO 2006/104860 (Sarnoff Corp.) describes silicate-silica-based polymorphous phosphors with the formula [(BvSiO₃)ₓ(Mv₂SiO₃)_{y}(Tv₂(SiO₃)₃)_{z}]ₘ (SiO₂)ₙ: Eu, Mn, X, wherein Bv is an alkaline earth metal ion, Mv is an alkaline metal ion, Tv is a trivalent metal ion, and X is a halogenide.

However, there is still room for improvement, e.g. of one or more of the properties listed below.
1. The chemical stability of these phosphors should be improved.
2. A lower thermal quenching would improve the power efficiency.
3. The temperature of the heat treatment in the current synthesis method of alumosilicates is high, so manufacturing methods which require a lower synthesis temperature would be desirable.

### Detailed Description of the Invention

During the development stage the inventors examined the emission mechanism of the luminescent centers of phosphors and aimed to solve the aforementioned problems.

Surprisingly, the inventors found that co-activated alumosilicate based phosphors according to the present invention can be produced which show improvements with respect to the above-mentioned disadvantages. In addition to other benefits, these phosphors show two emission peaks, enable a high thermal quenching resistivity, high chemical stability, and/or high color rendering properties, especially for red.

The present invention is therefore directed to a compound described by the formula (I):

(M_{1-x-y-z-w-e} Aₓ B_{y} C_{2z} D_{2w}) Si_{1-z-w-e} Al₂ₑ O₃ (I)

where
M is at least one cation selected from the group consisting of Ca, Sr and Ba,
A and B are different from each other and are selected from Pb²⁺, Mn²⁺, Yb²⁺, Sm²⁺, Eu²⁺, Dy²⁺ or Ho²⁺;
C and D are identically or differently at each occurrence, a trivalent cation and are selected form the groups consisting of Sc³⁺, Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺, and Bi³⁺;
0 ≤ x ≤ 0.3, 0 ≤ y ≤ 0.3, 0 ≤ z ≤ 0.3 and 0 ≤ w ≤ 0.3;
0.0001 ≤ e ≤ 0.2, preferably 0.01≤ e ≤ 0.2;
wherein x + y + z + w + e <1
wherein at least two of the indices x,
y, z and w are > 0.

A preferred embodiment of the present invention is the compound of the formula (II):

(M₁₋ₓ-_{y-z-e} Aₓ B_{y} C_{2z}) Si_{1-z-e} Al₂ₑ O₃ (II)

where the symbols and indices have the same meanings as those in formula (I).

In a preferred embodiment of the invention, the symbol A is Mn²⁺. In a further preferred embodiment of the invention, the symbol B is Eu²⁺. In a further preferred embodiment of the invention, the symbol C is Ce³⁺, Pr³⁺, Nd³⁺, Tb³⁺, Dy³⁺ or Ho³⁺, in particular Ce³⁺.

When the inventive compound comprises both, A and B, it is preferred that A is Mn²⁺ and B is Eu²⁺. When the inventive compound comprises both, A and C, it is preferred that A is Mn²⁺ and C is Ce³⁺, Pr³⁺, Nd³⁺, Tb³⁺, Dy³⁺ or Ho³⁺, in particular Ce³⁺. When the inventive compound comprises both, B and C, it is preferred that B is Eu²⁺ and C is Ce³⁺, Pr³⁺, Nd³⁺, Tb³⁺, Dy³⁺ or Ho³⁺, in particular Ce³⁺.

In a further preferred embodiment of the invention, M is selected from Ca and Sr, particularly preferred Ca.

In a preferred embodiment of the invention, two of the indices x, y, z and w are = 0 and the other two of the indices x, y, z and w are > 0. In a further preferred embodiment of the invention, w is = 0. In a particularly preferred embodiment of the invention, z and w are = 0 and x and y are > 0.

If the indices x, y, z and/or w are > 0, these indices are preferably independently between 0.02 and 0.2.

A particularly preferred embodiment of the present invention is therefore the compound of the following formula (III):

(M_{1-x-y-e} Aₓ B_{y}) Si₁₋ₑ Al₂ₑ O₃ (III)

wherein the symbols and indices have the same meaning as described above.

Very particularly preferred are compounds of formula (III) wherein A is Mn²⁺ and B is Eu²⁺.

The phosphors according to formulae (I), (II) and (III) have two emission peaks. The one of the two emission peaks is between 570 nm and 670 nm and the other is between 400 nm and 480 nm, respectively, and the CIE color coordinate is characterized by x = 0.34-0.53 and y = 0.24-0.41. By changing the proportion of the constituent Al in the silicate structure of the phosphors, the relative intensity of the two main emission peaks of the phosphors can be controlled. It is therefore possible to tune the emission color of the inventive phosphor by varying the Al content. Therefore, the presence of Al in the silicate structure of the phosphors is particularly important for white LEDs.

All processes for the preparation of a co-activated alumosilicate phosphors can be grouped into two general categories: solid-state diffusion (also called solid-phase or mixing and firing) and wet-chemical (also called solution synthesis). A wet chemical process is preferred for preparing the phosphors of the present invention, because this process augments their crystal quality and increases their purity and homogeneity. The inventors found that the preferred process is a wet-chemical process via the coprecipitation process (also called the hydrogen-carbonate precipitation process).

Wet chemical processes involve a lower temperature heat treatment compared with solid-state diffusion processes.

The term "solid state diffusion method" which refers to any mixing and firing method or solid-phase method, involves mixing oxidic starting materials as powders, optionally grinding the mixture, and then calcining the powders in a furnace at temperatures up to 1500°C for up to several days in an optionally reductive atmosphere (see, for example, Phosphor Handbook, second edition, CRC Press, 2006, 341-354).

The term "wet-chemical method" embraces the three following process embodiments in the context of the present invention.
- In the first preferred process embodiment, so-called hydrogen carbonate precipitation, firstly alkaline earth metal starting materials, preferably alkaline earth metal halides or nitrate, are dissolved in water with a dopant containing europium- and/or manganese; then, an inorganic or organic silicon-containing compound is added. Precipitation is carried out using a hydrogen carbonate solution, causing the slow formation of the phosphor precursor.
- In the second process embodiment, an organosilicon compound, preferably Si(OEt)₄, might be added to hydroxide solutions of the corresponding phosphor starting materials and a Eu- and/or Mn-containing dopant at elevated temperatures, causing the formation of the phosphor precursor.
- During the third process embodiment, which is the so-called oxalate precipitation, alkaline-earth metal halides are dissolved in water with a europium- and/or manganese halide and then added to a silicon-containing mixture consisting of a dicarboxylic acid and an inorganic or organic silicon compound. Increasing the viscosity causes the formation of the phosphor precursor.

Finally, the phosphor precursor must undergo a thermal after treatment (calcination) in order to become the final silicate-based phosphor. Aluminum can be added during the first two embodiments at anytime before the precipitation step.

During the preparation stage, it is preferred to use a micro-reaction system to make phosphors by a wet-chemicals process. In particular, the micro-reaction method is a preferable method to produce a phosphor precursor. In a small confined area of a flow channel (here after a microreactor) with an internal diameter ranging from 1 mm to 10 mm width, two or more solutions are mixed through a flow channel. In the microreactor, chemical reactions of the mixed solutions take place in a confinement with typical lateral dimensions below a few millimeters. It is easy to change a flow channel. It is possible to carry out the complex synthesis reaction, and synthesize complex materials composed of many elements easily. It is possible to make mixtures for phosphor precursors highly efficiently and to enhance reaction rates because it is easy to control the temperature, regulate the shape, yield improvement, and augment the safety of the process. Such a micro-reactor system also allows to control the size of the precursors and the homogeneity of the activators' distribution more easily than by other techniques.

The invention is furthermore directed to a process for the preparation of a phosphor of formulae (I), (II) and (III) comprising the following steps:
a) preparing a mixture of a silicon-containing agent and one or several salts containing the elements Al, M, and any of A, B, C and D, which should be present in the final phosphor, at a predetermined molar ratio in a solvent;
b) adding and mixing a precipitation agent;
c) performing a primary heat treatment on the mixture in a temperature range of 900 to 1300°C, preferably 950 to 1050°C, under an oxidative atmosphere (such as oxygen or air);
d) performing a secondary heat treatment on the mixture in a temperature range of 900 to 1300°C, preferably 950 to 1050°C, under a reductive atmosphere (such as using carbon monoxide, pure hydrogen, vacuum, or an oxygen-deficient atmosphere).

The actual composition ratio of the phosphor can be confirmed by wavelength dispersive X-ray spectroscopy (WDX), and the results of WDX can be used to predetermine the molar ratio of the salt containing the elements Al, M, A, B, C and D for the mixing step a).

For the preparation of the mixture in step a), it is possible to prepare a mixture of some or all of the salts and components as powders and then add the solvent or to prepare the mixture directly in a solvent.

The term "silicon containing agent" includes an inorganic silicon compound, preferably an oxide of silicon with a chemical formula SiO₂. It has a number of distinct crystalline forms (polymorphs) in addition to amorphous forms. The SiO₂ should be in small particles with a diameter of less than 1 µm; a diameter of less than 200 nm is even better. The "silicon containing agent" also refers to any organic silicon compounds, such as tetraalkyl ortho-silicates (alternately known as tetraalkoxy silanes), in particular tetraethoxysilane or tetramethoxysilane.

The Al salt (used in step a)) is preferably a nitrate, halogenide, hydrogensulfate or carbonate, particularly preferably nitrate or halogenide and most preferably nitrate.

For the elements M, A, B, C and D, a nitrate, halogenide, hydrogensulfate or carbonate is preferable as the salt which is used in step a). Particularly preferably, the salt for the elements M, A, B, C and D, is nitrate or halogenide and the most preferably, it is nitrate.

The salt including aluminum can be added anytime before the precipitation step (before step b)).

The term "solvent" is taken to mean a solvent that does not dissolve the Si-compound. Water and alcohols are the preferred solvents for this invention.

The most preferable precipitation agents (used in step b)) are sodium hydrogen carbonate, ammonium chloride, or ammonium hydrogen carbonate.

In a preferred embodiment of the invention, in the step b), the precipitation agents are added in the solvents and mixed with the solvents at around 60 °C and mixing time is 2 hours or more.

In a preferred embodiment of the invention, a pre-heat treatment step may be exist between the step b) and the step c) to evaporate the solution from the resultant solution of the step b) by an oven. Preferably the process temperature is at around 90 °C and the process atmosphere is not perticulary limited. Preferably, it is air.

In the step c), a generally known annealing oven can be used preferably with an oxidative atmosphere (such as oxygen or air). In a further preferred embodiment of the invention, a generally known oxidation furnace is used in the step c).

In the step d), a generally known annealing oven can be used preferably with a reductive atmosphere (such as carbon monoxide, pure hydrogen, vacuum, or an oxygen-deficient atmosphere). In a further preferred embodiment of the invention, a generally known reducing furnace is used in the step d).

The invention is furthermore directed to an illumination unit comprising the inventive phosphor with at least one light source that emits a light containing emission peak in the range of 250 nm to 450 nm, preferably the emission peak is between 350 nm and 410 nm. Moreover, the present invention requires all or some of this radiation to be converted into longer-wavelength radiation by at least one kind of phosphor. The light source of the illumination unit should comprise a luminescent UV and / or near UV LEDs or an indium aluminum gallium nitride semiconductor of the formula InᵢGaⱼAlₖN, where 0 ≤ i, 0 ≤ j, 0 ≤ k, and I + j + k = 1. In combination with corresponding inventive conversion phosphors and possibly further conversion phosphors, this source emits white or virtually white light.

It is preferable to use the alumosilicate phosphors of the present invention and another phosphor emitting light of a different color in the illumination unit. One option for another phosphor emitting light of a different color is a phosphor that emits green light, such as Ce-doped lutetium-containing garnet, Eu-doped sulfoselenides, thiogallates, BaMgAl₁₀O₁₇:Eu,Mn (BAM : Eu, Mn), SrGa₂S₄:Eu and/or Ce- and/or Eu-doped nitride containing phosphor, β-SiAlON:Eu. Another option is a phosphor that emits blue light, such as BAM: Eu or Sr₁₀(PO₄)₆Ct₂:Eu. Alternatively, one has the choice of using a phosphors that emits yellow light, such as garnet phosphors (e.g., (Y,Tb,Gd)₃Al₅O₁₂:Ce), ortho-silicates phosphors (e.g. (Ca,Sr,Ba)₂SiO₄: Eu), or Sialon-phosphors (e.g., α-SiAION: Eu). If one decides to go with the additional phosphor that emits green light, one would benefit the most by using ß-SiAION:Eu. Under the category of phosphors that emit yellow light, (Ca,Sr,Ba)₂SiO₄: Eu is particularly preferable.

In one embodiment of the invention, the phosphor or blend of phosphors in a matrix is disposed directly on the surface of the LED chip. In a further embodiment of the invention, the phosphor or blend of phosphors is arranged at a specific distance from the chip (remote phosphor). This also includes the use of the phosphor or blend of phosphors in form of a ceramic, optionally in a matrix material.

Another component of the present invention is a backlighting system that has at least one illumination unit according to the present invention. According to the invention, the backlighting system can be, for example, a "direct-lit" backlighting system or a "side-lit" backlighting system. The latter has an optical waveguide and an outcoupling structure. The backlighting system has a white light source, which is preferably located in a housing with a reflector on the inside. The backlighting system could also furthermore have at least one diffuser plate. The present invention further involves to a liquid-crystal display fitted with one or more backlighting systems according to the present invention.

A further aspect of the present invention is an electronic or electrooptical device comprising one or more phosphor blends. It also uses at least one compound according to the present invention in electronic or electrooptical devices.

Finally, the present invention is directed to the use of at least one compound according to formula (I) according to the invention as a conversion phosphor for blue or near-UV emission from a luminescent diode.

Owing to the low spectral response of solar cells, light with a short wavelength is not useful for generating electric power. However, it is possible to improve the efficiency of silicon solar cells (by using the conversion phosphors according to the invention). Thus, this invention is directed to the use of at least one compound according to formula (I) as wavelength conversion material in solar cells, preferably amorphous silicon solar cells.

### Definition of Terms

The term "thermal quenching" means an emission intensity decrease at higher temperature compared to an original intensity at 25 °C.

According to the present invention, the term "phosphor blend" is a phosphor mixture of two or more phosphors, which creates a new material with different physical properties.

The term "blue-emitting phosphor" refers to a phosphor with a wavelength at least one emission maximum between 435 nm and 507 nm.

The term "green emitting phosphor" refers to a phosphor with a wavelength of at least one emission maximum between 508 nm and 550 nm.

The term "yellow emitting phosphor" or "phosphor that emits yellow light" refers to a phosphor with a wavelength of at least one emission maximum between 551 nm and 585 nm.

The term "red-emitting phosphor" refers to a phosphor with a wavelength of at least one emission maximum between 586 and 670 nm.

Unless the context clearly indicates otherwise, the plural forms of the terms herein are to be construed as including the singular form and vice versa.

The term "oxidative atmosphere" is taken to mean an oxidating condition of the phosphor matrix material of the present invention. Air and oxygen atmosphere are preferable.

The term "reductive atmosphere" is taken to mean a reductive condition of the activators of the present invention. Carbon monoxide, pure hydrogen, hydrogen mixed with another gas such as nitrogen, vacuum, or an oxygen-deficient atmosphere is preferable.

Each feature disclosed in this specification, unless stated otherwise, may be replaced by alternative features serving the same, equivalent, or similar purpose. Thus, unless stated otherwise, each feature disclosed is but one example of a generic series of equivalent or similar features.

The invention is described in more detail in reference to the following examples, which are only illustrative and do not limit the scope of the invention.

### Examples

### Example 1: Preparation of (Ca_{0.775}, Mn²⁺_{0.1}, Eu²⁺_{0.1}) Si_{0.975}O₃: Al_{0.05}, (Al 2.5 mol%) with using the co-precipitation method

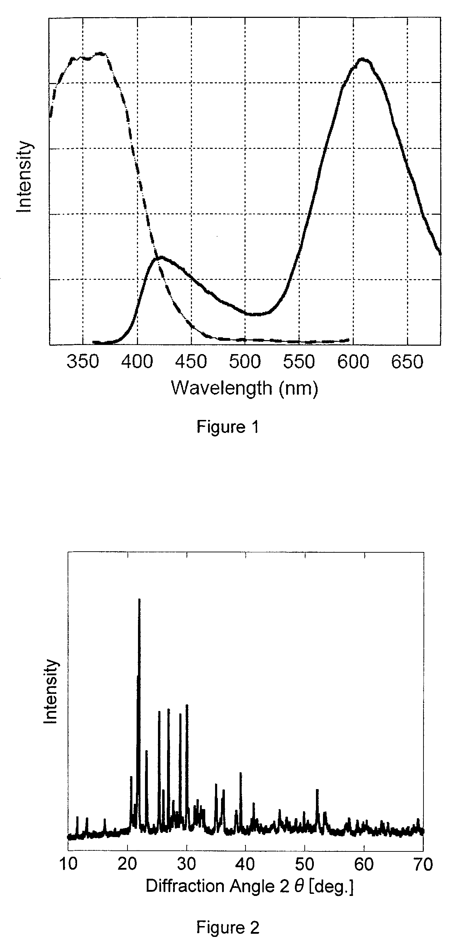

Al(NO₃)₃x9H₂O (0.0013 mol, Merck), Ca(NO₃)₂x4H₂O (0.019 mol, Merck), SiO₂ (0.025 mol, Merck), Eu(NO₃)₃x6H₂O (0.0025 mol, Auer-Remy), and Mn(NO₃)₂x4H₂O (0.0025 mol, Merck) were dissolved in deionized water. Then, NH₄HCO₃ (0.25 mol, Merck) was dissolved in deionized water. Finally, the two aqueous solutions were simultaneously stirred into deionized water. The resulting solution was evaporated to dryness at about 90 °C, and the resultant solid was annealed at 1000 °C for 4 hours in air. The resultant oxide materials were then annealed at 1000 °C for 4 hours in N₂ + 2.0 wt% H₂ atmosphere. After the conventional purification steps were performed with water and drying, the desired (Ca_{0.775}, Mn²⁺_{0.1}, Eu²⁺_{0.1}) Si_{0.975}O₃: Al_{0.05} was formed as evidenced by the XRD pattern shown in Figure 1. The composition ratio of the phosphor (Al/Si ratio) was confirmed by WDX. The phosphor showed a bright red emission with an emission maximum at a 615 nm upon 350 nm light excitation, as shown in Figure 2.

### Example 2: Preparation of (Ca_{0.75}, Mn²⁺_{0.1}, Eu²⁺_{0.1}) Si_{0.95}O₃: Al₀₁, (Al 5.0 mol%) with using the co-precipitation method

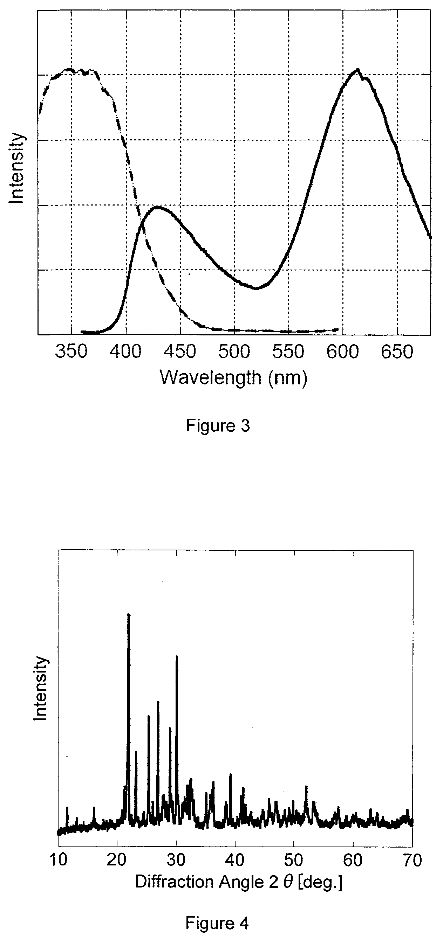

First, Al(NO₃)₃x9H₂O (0.0025 mol, Merck), Ca(NO₃)₂x4H₂O (0.019 mol, Merck), SiO₂ (0.024 mol, Merck), Eu(NO₃)₃x6H₂O (0.0025 mol, Auer-Remy), and Mn(NO₃)₂x4H₂O (0.0025 mol, Merck) were dissolved in deionized water. In another mixture, NH₄HCO₃ (0.25 mol, Merck) was dissolved in deionized water. The two aqueous solutions were then simultaneously stirred into deionized water. The resulting solution was evaporated to dryness at about 90 °C, and the remaining solid was annealed at 1000 °C for 4 hours in air condition. Finally, the resultant oxide materials were annealed at 1000 °C for 4 hours in N₂ + 2.0 wt% H₂ atmosphere. After conventional purification steps using water and drying were performed, the desired (Ca_{0.75}, Mn²⁺_{0.1}, Eu²⁺_{0.1}) Si_{0.95}O₃ : Al_{0.1}, (Al 5.0 mol%) was formed as evidenced by the XRD pattern that appears in Figure 3. The composition ratio of the phosphor (Al/Si ratio) was confirmed by WDX. The final phosphor product emitted a bright, red light peaking at a 615 nm upon 350 nm light excitation, as shown in Figure 4.

### Example 3: Preparation of (Ca_{0.7}, Mn²⁺_{0.1}, Eu²⁺_{0.1}) Si_{0.9}O₃: Al_{0.2}, (Al 10.0 mol%) with using the co-precipitation method

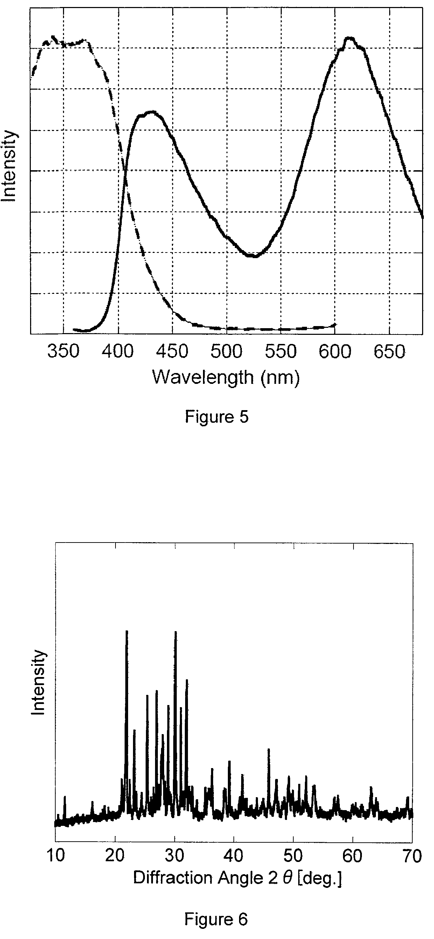

The following solutions were dissolved in deionized water: Al(NO₃)₃x9H₂O (0.005 mol, Merck), Ca(NO₃)₂x4H₂O (0.018 mol, Merck), SiO₂ (0.023 mol, Merck), Eu(NO₃)₃x6H₂O (0.0025 mol, Auer-Remy), and Mn(NO₃)₂x4H₂O (0.0025 mol, Merck). Another solution of NH₄HCO₃ (0.25 mol, Merck) was dissolved in deionized water. Then, the two aqueous solutions were simultaneously stirred into deionized water. The resultant solution was evaporated to dryness at about 90 °C, and the resultant solid was annealed at 1000 °C for 4 hours in air condition. The resultant oxide materials were annealed at 1000 °C for 4 hours in N₂ + 2.0 wt% H₂ atmosphere. Following the conventional purification steps of water and drying, the desired (Ca_{0.7}, Mn²⁺_{0.1}, Eu²⁺_{0.1}) Si_{0.9}O3 : Al_{0.2}, (Al 10.0 mol%) was formed as evidenced by the XRD pattern in Figure 5. The composition ratio of the phosphor (Al/Si ratio) was confirmed by WDX. The phosphor emitted a bright, red light peaking at a 615 nm upon 350 nm light excitation, which Figure 6 indicates.

### Example 4: Preparation of (Ca_{0.7}, Mn²⁺_{0.1}, Eu²⁺_{0.1}) Si_{0.9}O₃ : Al_{0.2}, (Al 10.0 mol%) with using the microreaction system

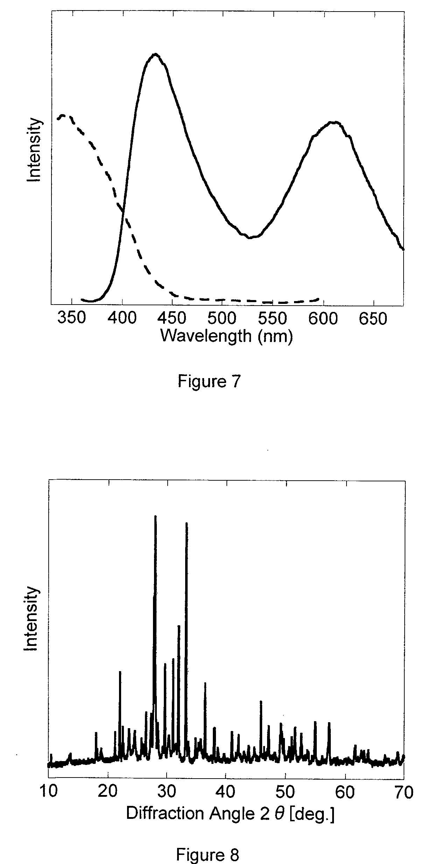

The influence on the product was investigated by changing the tube diameter and flow rate. Tube diameter influences activator distribution, and the flow rate influences the crystallinity. The manufacturing process of (Ca_{0.7}, Mn²⁺_{0.1}, Eu²⁺_{0.1}) Si_{0.9}O₃ : Al_{0.2}, (Al 10.0 mol%) involves the micro-reactor with 3 mm internal diameter and follows a sequence of steps. First, AlCl₃x9H₂O (0.005 mol, Merck), calcium chloride dihydrate, CaCl₂ x2H₂O (0.020 mol, Merck), silicon oxide, SiO₂ (0.025 mol, Merck), europium chloride hexahydrate, EuCl3 x 6H₂O (0.0025 mol, Auer-Remy), and manganese chloride tetrahydrate, MnCl₂x4H₂O (0.0025 mol, Merck) were dissolved in deionized water. Additionally, NH₄HCO₃ (0.25 g, Merck) was dissolved in deionized water. The solutions were pumped at the same time, and the reaction progressed at the connector. The reaction solution was then passed through the tube at about 60 °C. Precursors were caught in a beaker. The resultant solution was evaporated to dryness at about 90 °C, and the remaining solid was annealed at 1000 °C for 4 hours in air condition. The resultant oxide materials were annealed at 1000 °C for 4 hours in Nitrogen + 2.0 wt% hydrogen condition. After conventional purification steps using water and drying were performed, the desired (Ca_{0.7}, Mn²⁺_{0.1}, Eu²⁺_{0.1}) Si_{0.9}O₃ : Al_{0.2}, (Al 10.0 mol%) was formed as evidenced by the XRD pattern shown in Figure 7. The composition ratio of the phosphor was confirmed by WDX. The phosphor emitted a bright, red light peaking at a 615 nm upon 350 nm light excitation, as shown Figure 8.

### Example 5: Production and characterization of an LED and installing it in a liquid-crystal display

The phosphor from Example 1 was mixed with a silicone resin system OE 6550 from Dow Corning with the aid of a tumble mixer. The final concentration of phosphor in silicone was 8 wt%. The mixture was introduced into a cartridge that was connected to the metering valve of a dispenser. Raw LED packages were fixed in the dispenser. These consisted of bonded InGaN chips with a surface area of 1 mm² each, which emit a wavelength of 450 nm. The cavities of these raw LED packages were filled with the silicone phosphor by means of the xyz positioning of the dispenser valve. The LEDs treated in this way were then subjected to a temperature of 150°C, so that the silicone could solidify. The LEDs could then be put into operation and emit a white light having a color temperature of 6000 K.
Several of the LEDs produced above were installed in a backlighting system of a liquid-crystal display. A common LCD TV color filter was used to simulate a display environment and to calculate the color gamut that was realized by this LED.

### Example 6: Making a white LED with a 380 nm-emitting LED chip and a First Phosphor Blend

This phosphor blend was made of a red emitting co-activated silicate phosphor (Ca_{0.7}, Mn²⁺_{0.1}, Eu²⁺_{0.1}) Si_{0.9}O₃ Al_{0.2}, (Al 10.0 mol%), which came from the procedure in Example 3, and a green-emitting phosphor, BaMgAl₁₀O₁₇:Eu²⁺, Mn²⁺ (BAM:Eu, Mn). The two phosphors were mixed with the weight ratio of 1:1, and the phosphor blend (0.3 g) was further mixed with epoxy resin (10 g Silicone resin) to form a slurry. The slurry was applied to an InGaN-based LED chip that emits 380 nm wavelengths. The device generated light with white color, CIE 1937 (x, y) = (0.33, 0.33), and its whose color coordinates could be varied by changing the ratio of the three phosphors.

### Example 7: Measurement of thermal quenching

The phosphor from Example 1 was placed in a sample holder. Then, the holder was set to the FP6500 (from JASCO) under a thermal controller (from JASCO) that served as its TQ measurement system. The intensity of the emission spectra of the phosphor, which ranged from 380 nm to 780 nm was put under increasing temperatures and measured by the FP6500. The temperature began at 25 °C and climbed by increments of 25 °C until it reached 100 °C. As an exitation light source, which was a 150 W xenon lamp with an excitaion wavelength of 350 nm, was used. The phosphor of CaSiO₃ ·(SiO₂)₅: Eu²⁺, Mn²⁺ was placed in the sample holder and then prepared as the comparative example. Then, the holder was set to the FP6500, and the intensity of the emission spectra of CaSiO₃ · (SiO₂)₅: Eu²⁺, Mn²⁺ was measured under the same measurement conditions of the phosphor from Example 1.

The intensity of the emission spectra of the phosphor from Example 1 and the comparative example was integrated at each measurement. The integrated emission intensity of the phosphor from Example 1 was 8% better than the integrated emission intensity of the comparative example.

These results clearly show the efficacy of the thermal quenching resistivity of the phosphors according to the inventions.

### Description of the drawings

The invention will be explained in greater detail below with reference to illustrative embodiments:
Fig. 1: shows an emission spectrum of (Ca_{0.775}, Mn²⁺_{0.1}, Eu²⁺_{0.1}) Si_{0.975}O₃: Al_{0.05}, (Al 2.5 mol%) prepared by the co-precipitation method. Its fluorescence spectrum has emission maxima at about 610 nm and 425 nm.
Fig. 2: shows a XRD pattern (measured by the wavelength Cu_{Kα}) of (Ca _{0.775}, Mn²⁺_{0.1}, Eu²⁺_{0.1}) Si_{0.975}O₃: Al_{0.05}, (Al 2.5 mol%) prepared by the co-precipitation method.
Fig. 3: shows an emission spectrum of (Ca _{0.75}, Mn²⁺_{0.1}, Eu²⁺_{0.1}) Si_{0.95}O₃ : Al_{0.1}, (Al 5.0 mol%) prepared by the co-precipitation method. Its fluorescence spectrum has emission maxima at about 610 nm and 430nm
Fig. 4: shows a XRD pattern (measured by the wavelength Cu_{Kα}) of (Ca _{0.75}, Mn²⁺_{0.1}, Eu²⁺_{0.1}) Si_{0.95}O₃: Al_{0.1}, (Al 5.0 mol%) prepared by the co-precipitation method.
Fig. 5: shows an emission spectrum of (Ca_{0.7}, Mn²⁺_{0.1}, Eu²⁺_{0.1}) Si_{0.9}O₃ : Al_{0.2}, (Al 10.0 mol%) prepared by the co-precipitation method. Its fluorescence spectrum has emission maxima at about 610 nm and 430 nm.
Fig. 6: shows a XRD pattern (measured by the wavelength Cu_{Kα}) of (Ca_{0.7}, Mn²⁺_{0.1}, Eu²⁺_{0.1}) Si_{0.9}O₃ : Al_{0.2}, (Al 10.0 mol%) prepared by the co-precipitation method. Its fluorescence band peaks at about 610 nm and 415 nm.
Fig. 7: shows the emission spectrum of (Ca_{0.7}, Mn²⁺_{0.1}, Eu²⁺_{0.1}) Si_{0.9}O₃ : Al_{0.2}, (Al 10.0 mol%) prepared by a micro-reaction system.
Fig. 8: shows the XRD pattern (measured by wavelength Cu_{Kα}) of (Ca_{0.7}, Mn²⁺_{0.1}, Eu²⁺_{0.1}) Si_{0.9}O₃ : Al_{0.2}, (Al 10.0 mol%) prepared by the micro reaction system. Its fluorescence spectrum has emission maxima at about 610 nm and 415 nm.

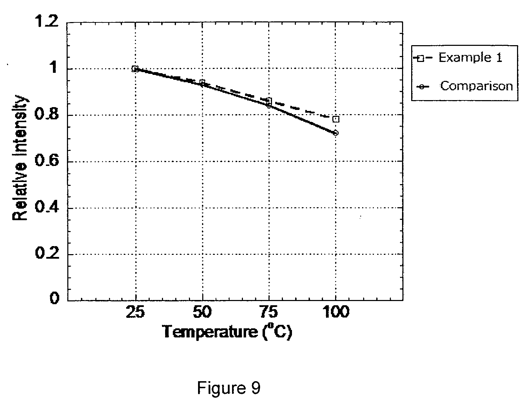

Fig. 9: shows the data of an emission intensity and thermal quenching.

## Claims

1. Compound of formula (I)
(M_{1-x-y-z-w-e} Aₓ B_{y} C_{2z} D_{2w}) Si_{1-z-w-e} Al₂ₑ O₃ (I)
where
M is at least one cation selected from the group consisting of Ca, Sr and Ba;
A and B are different from each other and are selected from Pb²⁺, Mn²⁺, Yb²⁺, Sm²⁺, Eu²⁺, Dy²⁺ or Ho²⁺;
C and D are identically or differently at each occurrence, a trivalent cation and are selected form the groups consisting of Sc³⁺, Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺, and Bi³⁺;
0 ≤ x ≤ 0.3, 0 ≤ y ≤ 0.3, 0 ≤ z ≤ 0.3 and 0 ≤ w ≤ 0.3; 0.0001 ≤ e ≤ 0.2;
wherein at least two of the indices x, y, z and w are > 0.

2. The compound according to Claim 1, **characterized in that** the compound is represented by the formula (II):
(M_{1-x-y-z-e} Aₓ B_{y} C_{2z}) Si_{1-z-e} Al₂ₑ O₃ (II)
where the symbols and indices have the same meaning as those in claim 1.

3. The compound according to Claim 1 or Claim 2, **characterized in that** the compound is represented by the formula (III):
(M_{1-x-y-e} Aₓ B_{y}) Si₁₋ₑ Al₂ₑ O₃ (III)
wherein the symbols and indices have the same meaning as those in claim 1.

4. The compound according to one or more of Claims 1 to 3, **characterized in that** the symbol A is Mn²⁺.

5. The compound according to Claim 2, there the symbol C is Ce³⁺, Pr³⁺, Nd³⁺, Tb³⁺, Dy³⁺ or Ho³⁺.

6. The compound according to one or more of Claims 1 to 5, where the symbol B is Eu²⁺.

7. The compound according to one or more of claims 1 to 6 where the symbol M is Ca.

8. The compound according to one or more of claims 1 to 7, where the indices x and y are identically or differently at each occurrence between 0.02 and 0.2.

9. The compound according to one or more of Claims 1 to 8, **characterized in that** the index e is between 0.01 and 0.2.

10. A process for the preparation of a phosphor according to one or more of claims 1 to 9, which includes the following process steps:
a) preparing a mixture of a silicon-containing agent and one or several salts containing the elements Al, M, and any of A, B, C and D, which should be present in the final phosphor, at a predetermined molar ratio in a solvent;
b) adding and mixing a precipitation agent;
c) performing a primary heat treatment on the mixture in a temperature range of 900 to 1300°C under an oxidative atmosphere; and
d) performing a secondary heat treatment on the mixture in a temperature range of 900 to 1300°C under a reductive atmosphere.

11. An illumination unit, which has at least one light source with an emission maximum in the range of 250 nm to 410 nm, and all or some of this radiation is converted into longer-wavelength radiation by a compound according to one or more of Claims 1 to 9.

12. The illumination unit according to claim 11 with a light source that is a luminescent indium aluminum gallium nitride which emits light in the range of 250 nm - 410 nm.

13. A backlighting system comprising at least one illumination unit according to claims 11 or 12.

14. An electronic or electrooptical device comprising a compound according to one or more of claims 1 to 9.

15. Use of at least one compound according to one or more of claims 1 to 9 as a conversion phosphor for conversion of all or some of the UV or near-UV emission from LEDs or as a wavelength conversion material for solar cells.

## Patentansprüche

1. Verbindung der Formel (I)
(M_{1-x-y-z-w-e} Aₓ B_{y} C_{2z} D_{2w}) Si_{1-z-w-e} Al₂ₑ O₃ (I),
wobei
M mindestens ein Kation ist, das aus der aus Ca, Sr und Ba bestehenden Gruppe ausgewählt ist;
A und B voneinander verschieden sind und aus Pb²⁺, Mn²⁺, Yb²⁺, Sm²⁺, Eu²⁺, Dy²⁺ oder Ho²⁺ ausgewählt sind;
C und D bei jedem Vorkommen gleich oder verschieden, ein dreiwertiges Kation und aus den aus Sc³⁺, Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺ und Bi³⁺ bestehenden Gruppen ausgewählt sind;
0 ≤ x ≤ 0,3, 0 ≤ y ≤ 0,3, 0 ≤ z ≤ 0,3 und 0 ≤ w ≤ 0,3; 0,0001 ≤ e ≤ 0,2;
wobei mindestens zwei der Indices x, y, z und w > 0 sind.

2. Verbindung nach Anspruch 1, **dadurch gekennzeichnet, dass** die Verbindung durch die folgende Formel (II) dargestellt wird:
(M_{1-x-y-z-e} Aₓ B_{y} C_{2z}) Si_{1-z-e} Al₂ₑ O₃ (II),
wobei die Symbole und Indices dieselbe Bedeutung haben wie in Anspruch 1.

3. Verbindung nach Anspruch 1 oder Anspruch 2, **dadurch gekennzeichnet, dass** die Verbindung durch die folgende Formel (III) dargestellt wird:
(M_{1-x-y-e} Aₓ B_{y}) Si₁₋ₑ Al₂ₑ O₃ **(III),**
wobei die Symbole und Indices dieselbe Bedeutung haben wie in Anspruch 1.

4. Verbindung nach einem oder mehreren der Ansprüche 1 bis 3, **dadurch gekennzeichnet, dass** das Symbol A für Mn²⁺ steht.

5. Verbindung nach Anspruch 2, wobei das Symbol C für Ce³⁺, Pr³⁺, Nd³⁺, Tb³⁺, Dy³⁺ oder Ho³⁺ steht.

6. Verbindung nach einem oder mehreren der Ansprüche 1 bis 5, wobei das Symbol B für Eu²⁺ steht.

7. Verbindung nach einem oder mehreren der Ansprüche 1 bis 6, wobei das Symbol M für Ca steht.

8. Verbindung nach einem oder mehreren der Ansprüche 1 bis 7, wobei die Indices x und y gleich oder verschieden bei jedem Vorkommen zwischen 0,02 und 0,2 sind.

9. Verbindung nach einem oder mehreren der Ansprüche 1 bis 8, **dadurch gekennzeichnet, dass** der Index e zwischen 0,01 und 0,2 beträgt.

10. Verfahren zur Herstellung eines Leuchtstoffes nach einem oder mehreren der Ansprüche 1 bis 9, das die folgenden Verfahrensschritte beinhaltet:
a) Herstellen eines Gemischs aus einem Silizium-enthaltenden Mittel und einem oder mehreren Salzen, die die Elemente Al, M und beliebige von A, B, C und D enthalten, die in dem endgültigen Leuchtstoff vorhanden sein sollten, in einem festgelegten Molverhältnis in einem Lösungsmittel;
b) Hinzufügen und Vermischen eines Fällungsmittels;
c) Durchführen einer ersten Wärmebehandlung an dem Gemisch in einem Temperaturbereich von 900 bis 1300°C unter einer oxidierenden Atmosphäre und
d) Durchführen einer zweiten Wärmebehandlung an dem Gemisch in einem Temperaturbereich von 900 bis 1300°C unter einer reduzierenden Atmosphäre.

11. Beleuchtungseinheit, die mindestens eine Lichtquelle mit einem Emissionsmaximum im Bereich von 250 nm bis 410 nm hat und wobei die gesamte oder ein Teil dieser Strahlung in längerwellige Strahlung durch eine Verbindung nach einem oder mehreren der Ansprüche 1 bis 9 umgewandelt wird.

12. Beleuchtungseinheit nach Anspruch 11 mit einer Lichtquelle, die ein lumineszierendes IndiumAluminiumGalliumNitrid ist, das Licht im Bereich von 250 nm - 410 nm emittiert.

13. Hintergrundbeleuchtungssystem, das mindestens eine Beleuchtungseinheit nach den Ansprüchen 11 oder 12 enthält.

14. Elektronisches oder elektrooptisches Gerät, das eine Verbindung nach einem oder mehreren der Ansprüche 1 bis 9 enthält.

15. Verwendung mindestens einer Verbindung nach einem oder mehreren der Ansprüche 1 bis 9 als Konversionsleuchtstoff zur Umwandlung der gesamten oder eines Teils der UV- oder Nah-UV-Emission von LEDs oder als Wellenlängenumwandlungsmaterial für Solarzellen.

## Revendications

1. Composé de la formule (I) :
(M_{1-x-y-z-w-e} Aₓ B_{y} C_{2z} D_{2w}) Si_{1-z-w-e} Al₂ₑ O₃ (I)
dans laquelle :
M est au moins un cation choisi parmi le groupe constitué par Ca, Sr et Ba ;
A et B sont différents l'un de l'autre et sont choisis parmi Pb²⁺,
Mn²⁺, Yb²⁺, Sm²⁺, Eu²⁺, Dy²⁺ et Ho²⁺ ;
C et D sont, de manière identique ou différente pour chaque
occurrence, un cation trivalent et sont choisis parmi les groupes constitués par Sc³⁺, Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺ et Bi³⁺ ;
0 ≤ x ≤ 0,3, 0 ≤ y ≤ 0,3, 0 ≤ z ≤ 0,3 et 0 ≤ w ≤ 0,3; 0,0001 ≤ e ≤ 0,2 ;
où au moins deux des indices x, y, z et w sont > 0.

2. Composé selon la revendication 1, **caractérisé en ce que** le composé est représenté par la formule (II) :
(M_{1-x-y-z-e} Aₓ B_{y} C_{2z}) Si_{1-z-e} Al₂ₑ O₃ (II)
dans laquelle les symboles et indices présentent la même signification que ceux selon la revendication 1.

3. Composé selon la revendication 1 ou la revendication 2, **caractérisé en ce que** le composé est représenté par la formule (III) :
(M_{1-x-y-e} Aₓ B_{y}) Si₁₋ₑ Al₂ₑ O₃ (III)
dans laquelle les symboles et indices présentent la même signification que ceux selon la revendication 1.

4. Composé selon une ou plusieurs des revendications 1 à 3, **caractérisé en ce que** le symbole A est Mn²⁺.

5. Composé selon la revendication 2, dans lequel le symbole C est Ce³⁺, Pr³⁺, Nd³⁺, Tb³⁺, Dy³⁺ ou Ho³⁺.

6. Composé selon une ou plusieurs des revendications 1 à 5, dans lequel le symbole B est Eu²⁺.

7. Composé selon une ou plusieurs des revendications 1 à 6, dans lequel le symbole M est Ca.

8. Composé selon une ou plusieurs des revendications 1 à 7, dans lequel les indices x et y sont, de manière identique ou différente pour chaque occurrence, entre 0,02 et 0,2.

9. Composé selon une ou plusieurs des revendications 1 à 8, **caractérisé en ce que** l'indice e est entre 0,01 et 0,2.

10. Procédé pour la préparation d'un phosphore selon une ou plusieurs des revendications 1 à 9, lequel inclut les étapes de procédé qui suivent :
a) préparation d'un mélange d'un agent contenant du silicium et d'un ou de plusieurs sel(s) contenant les éléments Al, M, et de l'un quelconque de A, B, C et D, lequel doit être présent dans le phosphore final, selon un rapport molaire prédéterminé dans un solvant ;
b) ajout et mélange d'un agent de précipitation ;
c) réalisation d'un traitement thermique primaire sur le mélange dans une plage de températures de 900 à 1300°C sous une atmosphère oxydative ; et
d) réalisation d'un traitement thermique secondaire sur le mélange dans une plage de températures de 900 à 1300°C sous une atmosphère réductrice.

11. Unité d'éclairage, laquelle comporte au moins une source de lumière présentant un maximum d'émission dans la plage de 250 nm à 410 nm, et la totalité de ce rayonnement ou une certaine partie de celui-ci est convertie selon un rayonnement de longueur d'onde plus longue par un composé selon une ou plusieurs des revendications 1 à 9.

12. Unité d'éclairage selon la revendication 11 munie d'une source de lumière qui est un nitrure indium aluminium gallium luminescent, laquelle émet de la lumière dans la plage de 250 nm - 410 nm.

13. Système d'éclairage arrière comprenant au moins une unité d'éclairage selon la revendication 11 ou 12.

14. Dispositif électronique ou électrooptique comprenant un composé selon une ou plusieurs des revendications 1 à 9.

15. Utilisation d'au moins un composé selon une ou plusieurs des revendications 1 à 9 en tant que phosphore de conversion pour la conversion de la totalité ou d'une certaine partie de l'émission des UV ou des UV proches en provenance de LED ou en tant que matériau de conversion de longueur d'onde pour des cellules solaires.
